# EUROPEAN PATENT APPLICATION

(11) **EP 4 625 609 A1**
(43) Date of publication of application: **01.10.2025**
(21) Application number: 24166260.0
(22) Date of filing: 26.03.2024
(51) Int. Cl.: H01M 10/48, G01R 31/396

(54) **SYSTEMS AND METHODS FOR ELECTRICAL ENERGY STORAGE CELL TEMPERATURE MONITORING**

(71) Applicant: Instagrid GmbH, 71636 Ludwigsburg (DE)
(72) Inventor: Zürner, Raphael, Ludwigsburg (DE); Gutknecht, Philipp, Mönsheim (DE); Zahn, Wolf, Stammheim (DE)
(74) Representative: Eisenführ Speiser

(57) **Abstract**

It is disclosed an energy module, comprising: electrical energy storage cells; temperature sensors configured to monitor temperatures of the electrical energy storage cells; a measurement tap in the network, which has a voltage value that will change responsive to a change of the shared current or voltage; and a circuit configured to detect an occurrence of a temperature error that is associated with one or more of the energy storage cells based on the voltage value at the measurement tap. Related methods and software products are also disclosed.

## Description

### BACKGROUND

### Description of the Related Art

Battery cell packs are often used to power electronic devices. The temperature of the battery cells thereof may be monitored during use of the same. Pinned or wired temperature sensors are often used for the temperature measurements. These temperature sensors are typically mounted in a way that a battery cell temperature is coupled strongly therewith. In this regard, each temperature sensor is manually placed at a position near the battery cell(s). Thereafter, the pins or wires of the temperature sensor may be soldered to a respective pad on a circuit board. In effect, the manufacturing process of the battery cell device is relatively manually intensive, inefficient, time consuming and costly.

### SUMMARY

The present disclosure concerns an energy module. The energy storage module comprises: a plurality of electrical energy storage cells; a plurality of temperature sensors configured to monitor temperatures of the plurality of electrical energy storage cells (wherein the plurality of temperature sensors are arranged in a network such that each temperature sensor shares a current or voltage with at least another temperature sensor in the plurality of temperature sensors); a measurement tap in the network, which has a voltage value that will change responsive to a change of the shared current or voltage, wherein the change in the shared current or voltage is caused by the temperatures of the plurality of electrical energy storage cells being monitored; and a circuit configured to detect an occurrence of a temperature error that is associated with one or more of the plurality of energy storage cells based on the voltage value at the measurement tap.

The present disclosure also concerns implementing systems and methods for operating an energy module. The methods comprise: monitoring temperatures of a plurality of electrical energy storage cells respectively by a plurality of temperature sensors (wherein plurality of temperature sensors are arranged in a network such that each temperature sensor shares a current or voltage with at least another temperature sensor in the plurality of temperature sensors); allowing a voltage value at a measurement tap to change responsive to a change of the shared current or voltage, wherein the change in the shared current or voltage is caused by the temperatures of the plurality of electrical energy storage cells being monitored; and comparing the voltage value to a reference voltage to detect an occurrence of a temperature error that is associated with one or more of the plurality of electrical energy storage.

### BRIEF DESCRIPTION OF THE DRAWINGS

The present solution will be described with reference to the following drawing figures, in which like numerals represent like items throughout the figures.
FIG. 1 provides a perspective view of a power supply.
FIG. 2 provides an illustrative block diagram of the power supply shown in FIG. 1.
FIG. 3 provides a perspective view of an energy module of the power supply shown in FIG. 1.
FIG. 4 provides an assembly view of the energy module shown in FIG. 3.
FIG. 5 provides an illustrative block diagram of a circuit in the energy module shown in FIGS. 3-4.
FIGS. 6-7 provide illustrations of an energy module that are useful for understanding a conventional placement of a temperature sensor therein.
FIGS. 8-10 provide illustrations that are useful for understanding an energy module circuit with a surface mount temperature sensor in accordance with the present solution.
FIG. 11 provides an illustration of another energy module circuit with a surface mount temperature sensor in accordance with the present solution.
FIG. 12 provides an illustration of an energy module circuit with an electrically isolating and thermally conductive member connected between a surface mount temperature sensor and a conductive terminal.
FIGS. 13A-13B (collectively referred to herein as "FIG. 13") provide illustrations of thermal isolation features.
FIGS. 14A-14B (collectively referred to herein as "FIG. 14") provide illustrations showing an energy module circuit having a plurality of conductive terminal and temperature sensors.
FIGS. 15A-15B (collectively referred to herein as FIG. 15) each provides an illustrative circuit diagram for an energy module.
FIG. 16 provides a graph showing a qualitative correlation between two temperatures represented by two parallel thermistors and a fixed threshold temperature value. This specific qualitative correlation in FIG. 16 is valid for a circuit of two negative temperature coefficient (NTC) thermistors in parallel (shared voltage).
FIG. 17 provides another illustrative circuit diagram for an energy module.
FIG. 18 provides yet another illustrative circuit diagram for an energy module.
FIG. 19 provides a flow diagram of an illustrative method for operating an energy module.
FIG. 20 provides a flow diagram of another illustrative method for operating an energy module.

### DETAILED DESCRIPTION

The present solution is described with reference to the attached figures. The figures are not drawn to scale and they are provided merely to illustrate the instant solution. Several aspects of the present solution are described below with reference to example applications for illustration. It should be understood that numerous specific details, relationships, and methods are set forth to provide a full understanding of the present solution. One having ordinary skill in the relevant art, however, will readily recognize that the present solution can be practiced without one or more of the specific details or with other methods. In other instances, well-known structures or operations are not shown in detail to avoid obscuring the present solution. The present solution is not limited by the illustrated ordering of acts or events, as some acts may occur in different orders and/or concurrently with other acts or events. Furthermore, not all illustrated acts or events are required to implement a methodology in accordance with the present solution.

It should also be appreciated that the terminology used herein is for the purpose of describing particular embodiments only and is not intended to be limiting of the present solution. As used herein, the singular forms "a", "an" and "the" are intended to include the plural forms as well, unless the context clearly indicates otherwise. Furthermore, to the extent that the terms "including", "includes", "having", "has", "with", or variants thereof are used in either the detailed description and/or the claims, such terms are intended to be inclusive in a manner similar to the term "comprising."

Further, unless otherwise defined, all terms (including technical and scientific terms) used herein have the same meaning as commonly understood by one of ordinary skill in the art to which this solution belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As noted above, conventional manufacturing processes of battery cell devices are relatively manually intensive, inefficient, time consuming and costly. Thus, there is a need for a battery cell design that facilitates an improved manufacturing process. The present solution is directed to a novel temperature sensor design that allows for an improved manufacturing process for battery devices with a cell temperature monitoring feature.

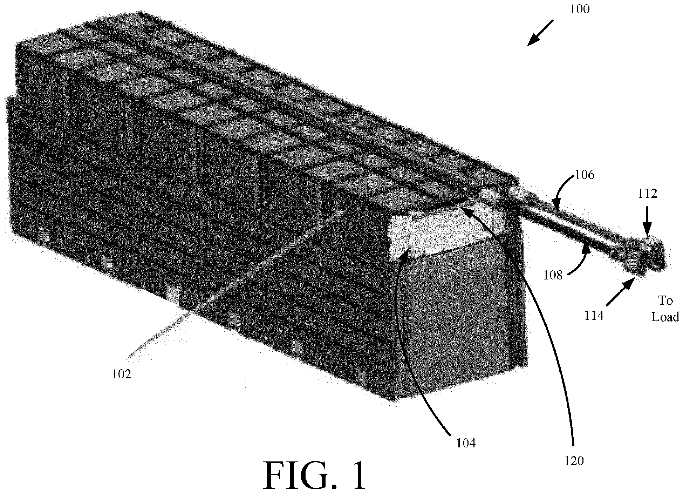

FIG. 1 provides an illustration of a power supply **100** which may be portable or otherwise mobile. The power supply **100** may have a size and weight to allow a single individual to carry the same with relative ease and/or to allow the same to be carried in a backpack or other bag. Power supply **100** may be connected in series or parallel with other power supplies to form a power supply unit.

Power supply **100** is generally configured to supply electric power to a load (not shown in FIG. 1). The load can include any electronic device that needs to be supplied power. Such loads can include, but are not limited to, another power supply, communication devices, media devices, golf carts, electric appliances, computing devices, and/or professional or home energy storage systems.

As shown in FIG. 1, the power supply **100** comprises a housing **102** in which a plurality of energy modules **104** are housed. Each energy module **104** is generally configured to convert direct current (DC) outputs from internal electrical energy storage cells into an alternating current (AC) output of the energy module. The electrical energy storage cells can include, but are not limited to, battery cells and/or super capacitors. The energy modules **104** are electrically connected to each other via insulated wires **106, 108.** In this way, the AC outputs of the energy modules are combined or otherwise summed together to produce the AC output power of the power supply **100.** More specifically, the energy modules **104** are connected in series in a controllable manner to supply different voltages at the output of the power supply **100.** Connectors **112, 114** are provided at the distal ends of insulated wires **106, 108** to provide a means to connect the output of the power supply **100** to the load.

In some uses, more than one instance of the power supply **100** may be coupled together to obtain a larger capacity power supply and/or a multi-voltage power supply. Such plurality of instances of the power supply **100** may, for example, be enclosed in a common housing (not shown in FIG. 1). It is further possible to obtain multi-phase power supplies using multiple instances of the power supply **100.** It shall be appreciated that such arrangements may further benefit from a reliable thermal monitoring of the electrical energy storage cells which are packed together.

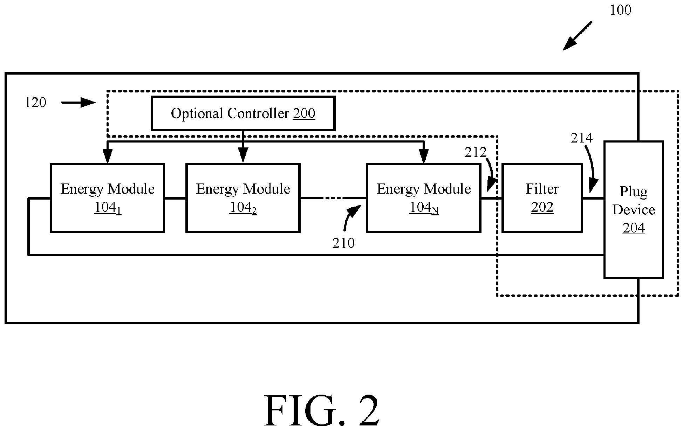

Operation of the energy modules **104** may be controlled using an internal circuit **120.** An illustrative technique for controlling the energy modules will now be discussed in relation to the block diagram of FIG. 2. The energy modules are referred to in FIG. 2 by reference numbers **104₁, 104₂,** ..., **104_{N}**. The energy modules **104₁, 104₂,** ..., **104_{N}** are collectively referred to herein as energy modules **104. N** is an integer equal to or greater than one.

As shown in FIG. 2, circuit **120** may comprise an optional controller **200,** a filter **202** and a plug device **204.** Controller **200** may reside external to the power supply **100** in some scenarios in which the power supply **100** comprises part of a grid. The grid can include a plurality of power supplies that are connected to each other and controlled by a unit controller. Controller **200** is shown internal to the power supply **100** for ease of illustration and explanation of the system operations. However, the present solution is not limited to the shown configuration. The plug device **204** may include the wires (e.g., wires **106, 108** of FIG. 1), connectors (e.g., connectors **112, 114** of FIG. 1), and/or other components to facilitate the supply of power to a load.

The controller **200** is configured to selectively activate and deactivate the energy modules **104** for causing the power supply **100** to deliver AC power to the load with the correct voltage, current and frequency. The controller **200** is connected to each of the energy modules **104₁, 104₂,** ..., **104_{N}** so that the energy modules can be controlled individually thereby. The controller **200** is configured to selectively transition each energy module between a battery mode and a bypass mode. When an energy module is in its battery mode, the internal electrical energy storage cells are switched into the circuit such that they are connected between terminals **210, 212** thereof. As such, a voltage output from the electrical energy storage cells is provided at terminal **210** and **212.** In contrast, when the energy module is in a bypass mode, the internal electrical energy storage cells are bypassed such the terminals **210, 212** are directly shortened to each other. In effect, no voltage from the electrical energy storage cells is provided at terminal **210** or **212** of the energy module.

Particularly, an energy module may provide the following operation modes: a Hi-Z (high impedance) mode in which module output is set to a high-impedance state (e.g., associated with none of the switches in the module being turned ON); a bypass mode in which the energy module is not contributing any battery voltage, but letting the current flow via it (e.g., via both low-side switches of the H-bridge being turned ON); a conducting + mode in which the electrical energy storage cells are connected to the module output in a given polarity; and a conducting - mode in which the electrical energy storage cells are connected to the module output in an opposite polarity as compared to the conducting + mode.

By successively transitioning the energy modules from the bypass mode to the battery mode, the combined output voltage of the energy modules **104** can be increased in steps. Similarly, by successively transitioning the energy modules from the battery mode to the bypass mode, the combined output voltage of the energy modules **104** can be decreased in steps. The combined output voltage can be changed by an amount equal to the output voltage ***V_{M}*** of one energy module. Thus, the combined output voltage ***V_{C}*** can vary between zero volts and **N** times ***V_{M}*** Volts (i.e., 0 Volts < ***V_{C}*** < N· ***V_{M}*** Volts). For obtaining finer transition between the ***V_{M}*** steps, at least one energy module can be operated in a pulse-width-modulation (PWM) mode with time varying duty-cycle. The combined output voltage ***V_{C}*** can be smoothed by filter **202** so as to produce a voltage signal on line **214.** The voltage signal on line **214** may have sinusoidal characteristics, DC signal characteristics or other waveform characteristics.

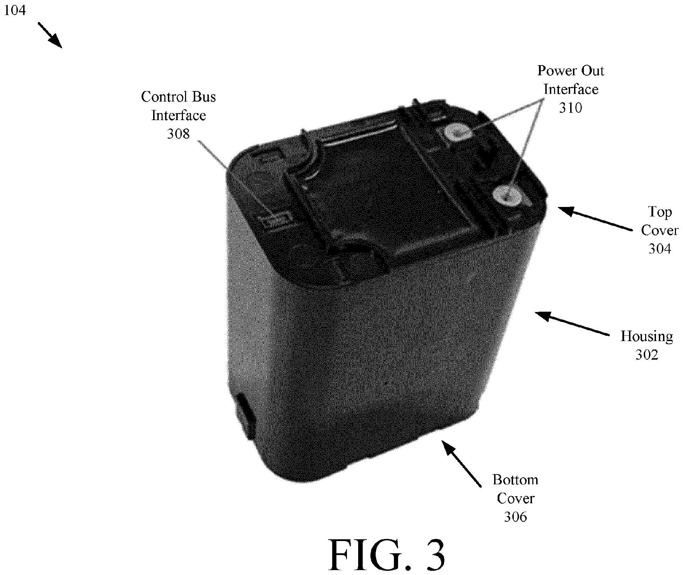

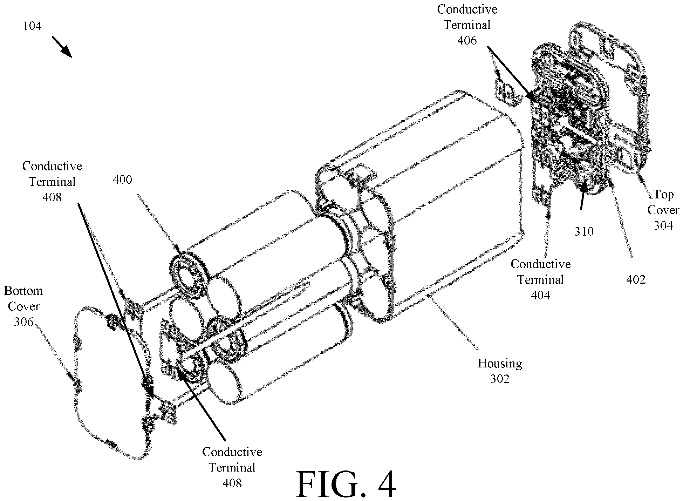

FIG. 3 provides an illustration of an energy module **104.** An assembly view of the energy module **104** is provided in FIG. 4. Energy modules **104** of FIG. 1 and 104**₁, 104₂,** ..., **104_{N}** of FIG. 2 may be the same as or similar to the energy module shown in FIG. 3.

Energy module **104** comprises a housing **302** in which electrical energy storage cells **400** are housed so as to maintain certain positions relative to each other. The electrical energy storage cells **400** can be arranged in two rows of three cells as shown in FIGS. 3-4. The present solution is not limited in this regard. The electrical energy storage cells can have a different arrangement than that shown in FIGS. 3-4. Any number of electrical energy storage cells can be provided in the energy module in accordance with a given application. Each electrical energy storage cell may include, but is not limited to, a lithium-ion cell. Hence, the energy module **104** may comprise electrical energy storage cells which are in the form of an electrical battery, capacitor or supercapacitor, their likes or their combinations. The electrical energy storage cell, lithium-ion cell, may have a cylindrical shape as shown or another shape (e.g., a rectangular shape) not shown.

A top cover **304** and a bottom cover **306** are provided for the housing **302.** The covers **304, 306** may be configured to provide an environment seal with the housing **302.** The environmental seal may be facilitated by gaskets (not visible or shown in FIGS. 3-4) compressed between the covers **304, 306** and the housing's sidewalls.

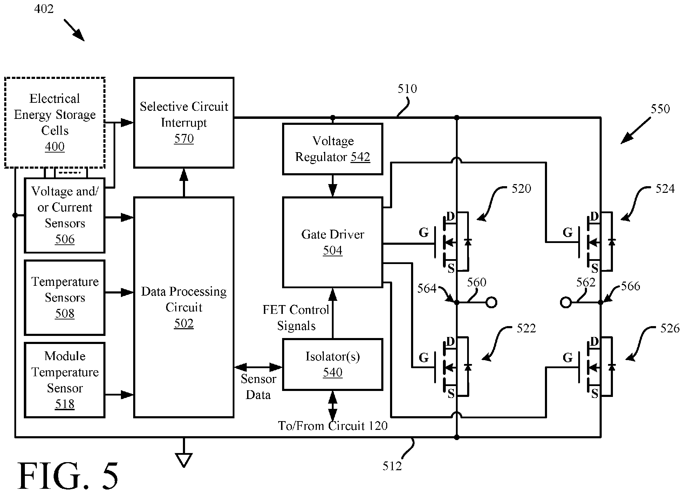

The safe and reliable operation of the energy module **104** requires the constant monitoring of each electrical energy storage cell **400** to detect when its current, voltage and/or temperature fall outside of defined operating range(s). This monitoring is achieved using a circuit **120** that is also housed in the housing **302.** Conductive terminals **404, 406, 408** are provided to connect the electrical energy storage cells **400** to the circuit **120** for at least voltage measurements. A more detailed block diagram of circuit **402** is provided in FIG. 5.

As shown in FIG. 5, circuit **402** comprises voltage and current sensors **506** connected to the electrical energy storage cells **400.** These sensors **506** are configured to measure the voltage and/or current of each electrical energy storage cell. Circuit **402** also comprises temperature sensors **508** and a module temperature sensor **518.** Each temperature sensor **508** is configured to measure a temperature of one or more electrical energy storage cells, while the module temperature sensor **518** is configured to measure an internal temperature of the energy module. More specifically, the temperature sensor senses the temperature close to the power stage consisting of FETs **520, 522, 522, 526.** These sensor measurements are communicated from the sensors **506, 508, 518** to the data processing circuit **502** for processing and measurement acquisition. The data processing circuit **502** can perform operations to communicate sensor measurements as sensor data to circuit **402,** and/or perform operations to analyze the sensor measurements to determine if certain criteria is met. For example, if a parameter measurement falls outside of defined range at a given time or for a certain amount of time, then the data processing circuit **502** causes the circuit interrupt **570** to transition from a closed state to an open state such that the power input and output of the energy module **104** is turned off. The parameter measurement can include a voltage measurement, a current measurement or a temperature measurement.

The circuit **402** also comprises a gate driver **504** and a transistor active bridge **550.** The transistor active bridge circuit **550** is supplied a DC waveform from the electrical energy storage cells **400.** As such, the transistor active bridge **550** is connected to electrical energy storage cells **400** via input lines **510, 512.** The transistor active bridge **550** is also connected between a pair of output lines **560, 562.** The output lines **560, 562** are connected to the power interface **210/212** of FIG. 2 and/or **310** of FIG. 3.

The transistor active bridge **550** includes a plurality of switches, shown in this example as field-effect transistors (FETs) **520, 522, 524, 526** of an N-channel type. Each of the FETs may comprise a metal-oxide semiconductor FET (MOSFET). Alternatively, other kinds of switches are also possible, such as but not limited to bipolar junction transistor (BJT) or insulated gate bipolar transistor (IGBT) based switches, or even relays. Each FET **520, 522, 524, 526,** in this example, has three (3) terminals respectively defined as a source **S,** a gate **G** and a drain **D.** An electrical path is be provided from the source to the drain of each FET **520, 522, 524, 526.** This path is generally referred to herein as the source-drain path. A source-drain path of first FET **520** is connected in series with a source-drain path of the second FET **522.** The series connected transistor pair **520, 522** form a first series transistor combination that is connected across the input lines **510, 512.** A source-drain path of the third FET **524** is connected in series with a source-drain path of the fourth FET **526** to form a second series transistor combination connected across the input lines **510, 512.**

The transistor active bridge **550** can have an output defined by output lines **560, 562.** A first one of the output lines **560** can be connected to the first series combination **520, 522** at an interconnection point **564** between the first and the second field-effect transistors **520, 522.** A second one of the output lines **562** can be connected to the second series combination **524, 526** at an interconnection point **266** between the third and fourth field-effect transistors **524, 526.**

Gate driver **504** is provided for driving the gate **G** of each FET **520, 522, 524, 526.** In this regard, the gate driver is configured to supply a voltage to the gate **G** of each FET at certain times for switching the FET to its "on" state or "off' state. The gate driver is also configured to stop supplying the voltage to the gate **G** of the FET at certain times for switching the FET to its "on" state or "off' state. Gate driver circuits are well known. Known or to be known gate driver circuit can be used here. In some cases, the gate driver **504** may be realized as different circuits for each or some of the FETs **520, 522, 524, 526.**

When the gate driver **504** communicates gate control signals to the FETs **520, 526,** the FETs **520, 526** will be biased and switch to their "on" states, thus providing voltage from the energy storage cells **400** at the output lines **560, 562.** In effect, current may flow between the drain **D** and source **S** of these FETs to supply a load connected between the output lines **560, 562.** The FETs **520, 526** transition back to their "off' states when the gate control signals are no longer being output from the gate driver circuit. Similarly, when the gate driver **504** communicates gate control signals to the FETs **522, 524,** the FETs **522, 524** will be biased and switched to their "on" states, thus providing voltage from the energy storage cells **400** at the output lines **560, 562** but in the opposite polarity as compared to the "on" state of the FETs **520** and **526.** In effect, current may flow between the drain **D** and source **S** of these FETs **522, 524** to supply a load connected between the output lines **560, 562.** It shall be appreciated that the load will experience current in opposite polarity in case FETs **522, 524** are "on", as compared to the case when FETs **520, 526** are "on". The FETs **522, 524** transition back to their "off' states when the gate control signals are no longer being output from the gate driver. The gate driver may be configured to prevent the two FETs in each series pair **520/526** and **522/524** from being closed simultaneously or concurrently.

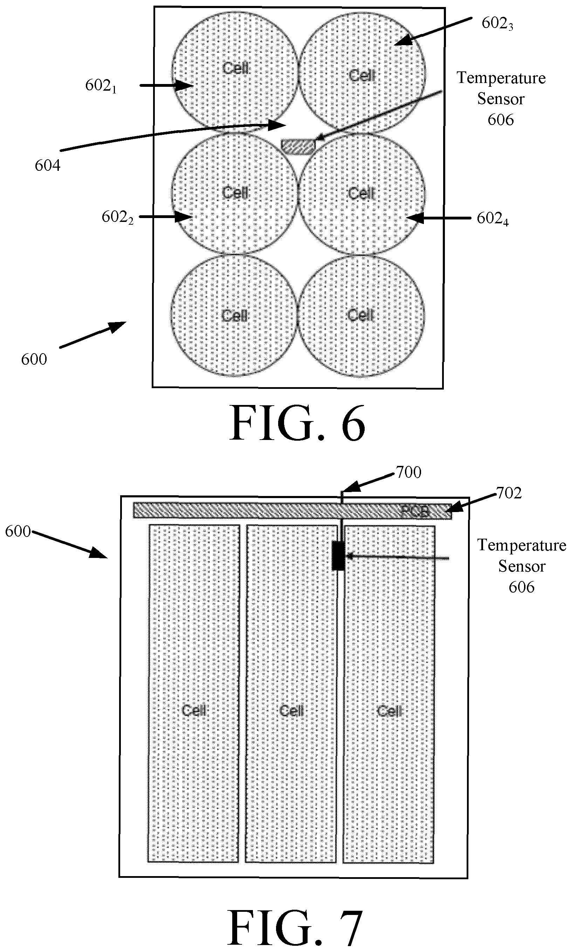

The manufacturing process of conventional energy modules is relatively manually intensive, inefficient, time consuming and costly. This is at least partially due to the use of wired or pinned temperature sensors for cell temperature measurements. FIGS. 6-7 provide illustrations that are useful for understanding the conventional temperature sensor architecture of an energy module. This conventional architecture comprises a temperature sensor **606** that is mounted so as to extend into an empty space **604** between electrical energy storage cells **602₁**, **602₂**, **602₃**, **602₄** and so as to be located proximate to electrical energy storage cells **602₂**, **602₄**. In this way, the temperature of electrical energy storage cells **602₂**, **602₄** are coupled with the temperature sensor **606.** For example, the temperature sensor **606** can include a through-hole-technology (THT) sensor. The pin(s) **700** of the temperature sensor **606** is soldered to a circuit board **702.** The placement of the temperature sensor **606** amongst the electrical energy storage cells and the soldering of the temperature sensor **606** to the circuit board **702** are manually performed during a manufacturing process of the energy module **600.**

The present solution provides a novel temperature sensor architecture for an energy module that eliminates the need for a pined temperature sensor in an energy module and therefore also eliminates the manual process. This is achieved through the use of a surface mount (SMT) sensor for measuring cell temperature. The SMT sensor is more suitable for an automated manufacturing process for the energy module with a minimized cost and time.

It should be noted that the SMT temperature sensor mounted on a circuit board may be more influenced by temperature sources on the same circuit board rather than by the electrical energy storage cells. Moreover, a farther proximity of an SMT sensor from the electrical energy storage cells may cause reduction in temperature measurement capability or reliability. Thus, the present solution addresses this issue by maximizing the thermal conductivity from the SMT temperature sensor to the electrical energy storage cell and minimizes the thermal conductivity from SMT temperature sensor to other temperature sources on the circuit board. The manner in which this is accomplished will become evident as the discussion progresses. However, in general, this is achieved with SMT temperature placement, circuit board layout, use of cell voltage sense connections and/or other optional aspects to improve or reduce thermal conductivity in one or other direction.

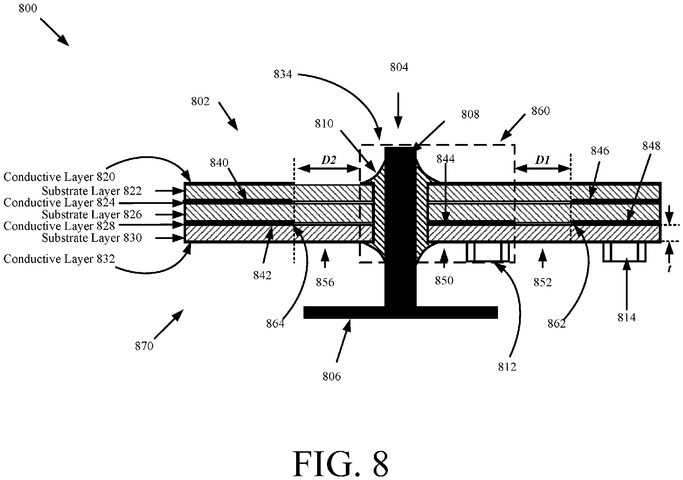

FIG. 8 provides a perspective view of an illustrative architecture for an internal circuit 800 of an energy module. The energy module can include, but is not limited to, energy module **104** of FIG. 1, energy module **104₁,** ..., **104_{N}** of FIG. 2, or the energy module of FIG. 3. The circuit **402** of FIGS. 4-5 can be the same as or similar to circuit **800** of FIG. 8.

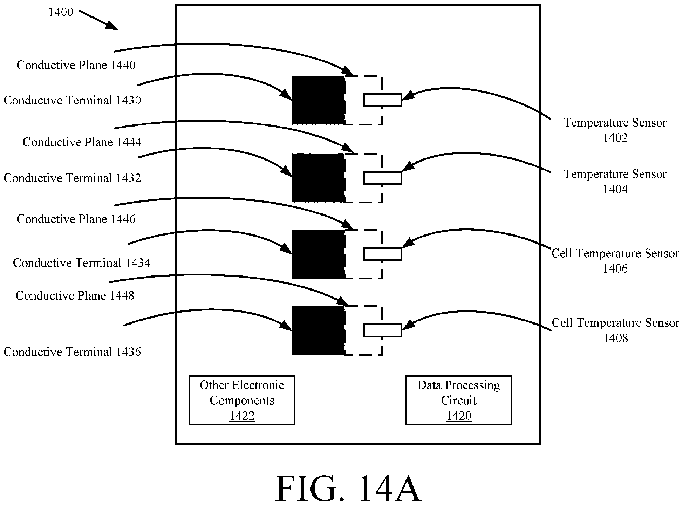

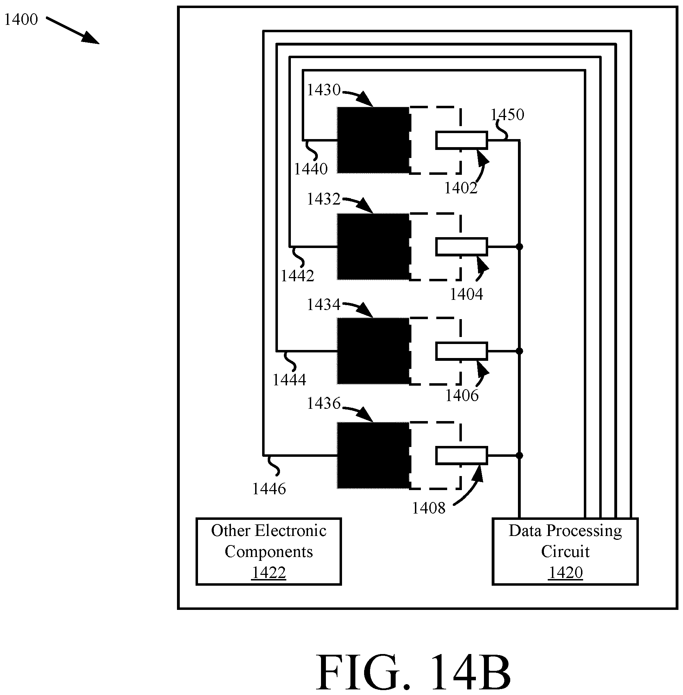

As seen in FIG. 8, internal circuit **800** will be described in relation to a single conductive terminal **804** and a single temperature sensor **812** for simplicity of discussion. Conductive terminal **804** can be configured to facilitate cell voltage measurements. In other words, the main purpose of the conductive terminal **804** may be to provide electrical signals at the internal circuit **800.** However, it should be understood that internal circuit **800** can include any number of conductive terminals and temperature sensors selected in accordance with a particular application. For example, as shown in a top view of FIG. 14, the circuit can include four conductive terminals and four temperature sensors. The present solution is not limited to the particulars of FIG. 14. The following discussion is sufficient for understanding the architecture for each pair of sensors **804, 812** provided with an internal circuit of an energy module.

It should also be noted that a data processing circuit (e.g., data processing circuit **502)** is electrically connected to the conductive terminal **804** and the temperature sensor **812** so that voltage and temperature measurements can be received thereby. The data processing circuit is configured to detect when voltage and temperature measurements fall outside of pre-specified ranges. The data processing circuit and these electrical connections are not shown in FIG. 8 for ease and simplicity of illustration.

The conductive terminal **804** comprises a distal end **806** that can be welded or otherwise coupled to electrical energy storage cells. The conductive terminal **804** can include, but is not limited to, conductive terminal **404** of FIG. 4. The temperature sensor **812** can include, but is not limited to, a surface mount thermistor or other surface mount temperature sensor.

In addition to the components **804** and **812,** circuit **800** comprises other electronic component(s) **814** mounted on a multi-layer circuit board **802.** The electronic component(s) can include, but are not limited to, resistor(s), capacitor(s), inductor(s), amplifier(s), filter(s), selective circuit interrupt(s) (e.g., selective circuit interrupt **570** of FIG. 5), voltage regulator(s) (e.g., voltage regulator **542** of FIG. 5), isolator(s) (e.g., isolators **540** of FIG. 5), processor(s) (e.g., data processing circuit **502** of FIG. 5), gate driver(s) (e.g., gate driver **504** of FIG. 5), a transistor active bridge circuit (e.g., transistor active bridge circuit **550** of FIG. 5).

Multi-layer circuit board **802** comprises substrate layers **822, 826, 830** and conductive layers **820, 824, 828, 832.** The exact number of layers which the circuit board **802** have is not essential or limiting to the present teachings. Substrate layers **822, 826, 830** are formed of the same or different dielectric material. Each of the conductive layers **820, 824, 828, 832** may comprise one or more conductors **840, 842, 844, 846, 848** formed thereon. Conductors **840, 842, 844, 846, 848** can include, but are not limited to, traces.

A through-hole pad **834** is formed through the circuit board **802.** A connection member **808** of the conductive terminal **804** extends through the through-hole pad **834.** Solder may be used to couple the connection member **808** to the circuit board **802** and provide an electrical connection between the conductive terminal **804** and conductor **844.** This connection is referred to as a conductive connection **810.** The conductive connection **810** can include, but is not limited to, a solder joint.

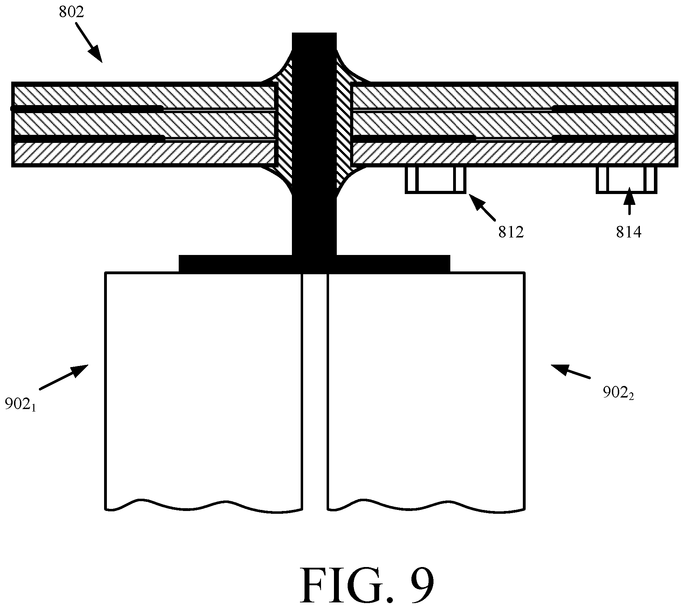

The temperature sensor **812** is mounted on a side **870** of the circuit **800** which faces the electrical energy storage cells **902₁**, **902₂** when the energy module is assembled as illustrated in FIG. 9. The temperature sensor **812** is located proximate to the conductive terminal **804** and conductor **844** so that it can detect the temperature of the electrical energy storage cells **902₁**, **902₂** via the conductive terminal **804.** Since the distal end **806** of the conductive terminal 804 is conductively connected directly to the electrical energy storage cells **902₁**, **902₂**, the conductive terminal **804** also provides relatively good thermal conductivity suitable for cell temperature measurements, while providing the main purpose of relatively good electrical conductivity suitable for cell voltage measurements. Hence, an electrical component having the main purpose of establishing electrical connection is further leveraged to obtain more accurate temperature measurements in a non-contact fashion with a device-under-monitoring. It shall be appreciated that the "device-under-monitoring" in this case would be one or more of the electrical energy storage cells.

It should be noted that the temperature sensor **812** is electrically not directly connected to the conductive terminal **804.** An electrical isolation between the temperature sensor **812** and the conductive terminal **804** is facilitated by the design of the multi-layer circuit board **802,** the relatively positions of the two components **804, 812,** and the relative positions of components **812, 844.** First, the thickness ***t*** of the substrate layer **830** is selected to be relatively thin. For example, this thickness ***t*** is selected to be less than 0.2 mm in some scenarios to ensure that conductive layers **828, 832** are located relatively close to each other. Second, a conductive trace or plane **844** is disposed on conductive layer **828** (i) so as to be electrically connected to the conductive terminal **804** via conductive connection **810** and (ii) so that it resides directly in proximity to (e.g., above) the temperature sensor **812.** The size, shape and/or material of the conductive plane **844** can be selected to maximize thermal conductivity to the temperature sensor **812.** For example, the conductive plane **844** may substantially overlap or extend the region occupied by the temperature sensor **812** on the layer **832.** The conductive plane **844** is formed of a conductive material configured to provide thermal conductivity with the conductive terminal **804.** The conductive material can include, but is not limited to, copper, tin, gold or other materials or alloys. The data processing circuit may be electrically connected to the conductive terminal via the conductive plane. Thus, the conductive plane **844** may be leveraged also as a thermal conductor for the temperature sensor **812** besides performing its main task of routing or establishing electrical connection of the conductive terminal **804** with other electrical components. This can save space and costs. This can also simplify production process, e.g., assembly of the energy module **300.** By preventing leaded temperature sensor, deformed sensor leads can be avoided in production. This can enhance production yield of assembled modules.

The substrate layer **830** is formed of a material configured to provide thermal conductivity and electrical isolation between conductive connection **810** and temperature sensor **812** and between conductive plane **844** and temperature sensor **812.** The temperature sensor **812** is disposed on the circuit board **802** at a location that provides a gap **850** between itself and the connection member **808** of the conductive terminal **804.** The size of gap **850** is selected to ensure that the temperature sensor is electrically isolated from the conductive connection **810.** Thus, the structure can allow a good thermal contact to the temperature sensor **812** despite being electrically isolated from the conductive terminal **804.**

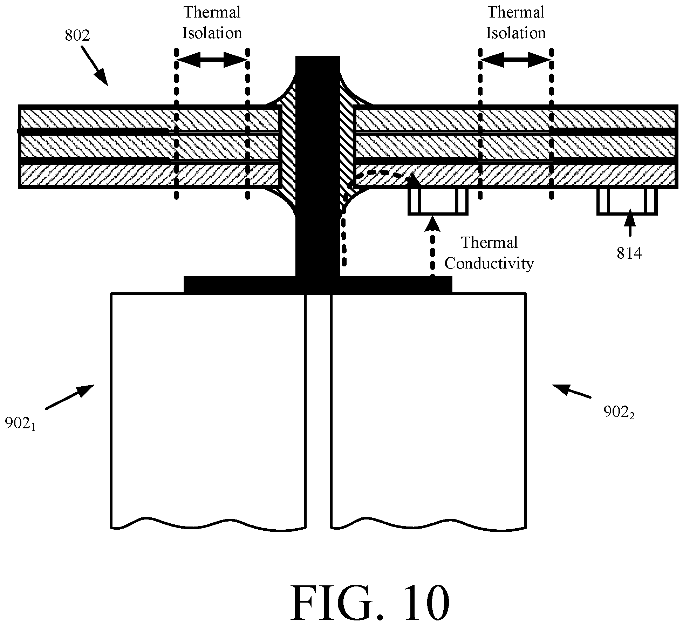

In FIG. 8, area **860** includes the conductive connection **810** and the temperature sensor **812.** Area **860** is thermally isolated from other electrical components of circuit **800.** The other electrical components include conductors **840, 842, 846, 848** and electronic component(s) **814.** A gap **852** is provided between area **860** and components **814, 846, 848.** The size and shape of gap **852** is selected so that area **860** is located at least a given distance ***D1*** from a closest edge **862** of each conductor **846, 848.** A gap **856** is also provided between area **860** and conductors **840, 842.** The size and shape of gap **856** is selected so that area **860** is located at least a given distance ***D2*** from a closest edge **864** of each conductor **840, 842.** Distances ***D1*** and ***D2*** are selected to ensure that there is a minimized amount of thermal conductivity between area **860** and components **814, 840, 842, 846, 848** of circuit **800.** An illustration is provided in FIG. 10 which shows the areas of thermal isolation and conductivity of circuit **800.**

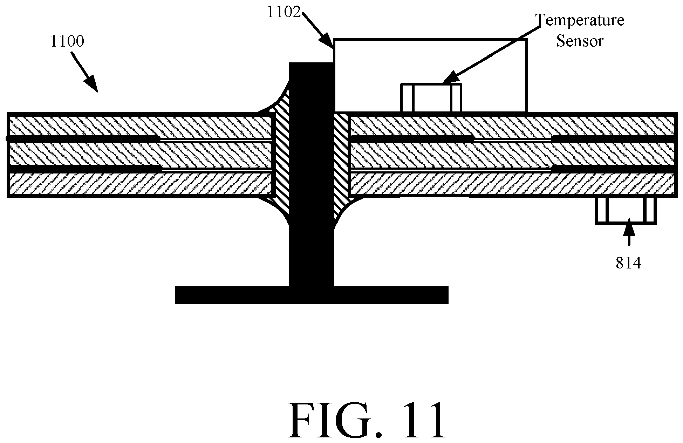

The present solution is not limited in the architecture shown in FIGS. 8-10. The temperature sensor could alternatively reside on the opposite side **1100** of the circuit board which faces away from the electrical energy storage cells as shown in FIG. 11. This alternative placement of the temperature sensor enables accessibility thereto after soldering a distal end of the conductive terminal to the circuit board. After soldering the distal end of the conductive terminal to the circuit board, the temperature sensor and the conductive connection could be thermally connected and still electrically isolated by any suitable material **1102.** This material **1100** can include, but is not limited to, a potting material, thermal glue and/or thermal paste.

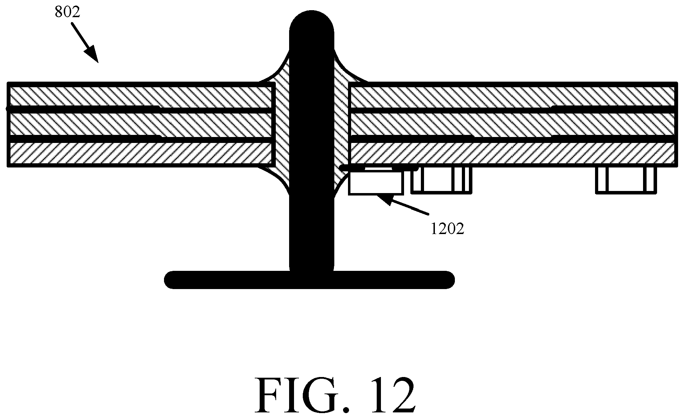

Alternatively or additionally, the thermal conductivity from the conductive connection **810** to the temperature sensor may be improved using one or more electrically isolating and thermally conductive member as shown in FIG. 12. The electrically isolating and thermally conductive member(s) **1202** can include, but are not limited to, a thermal jumper, thermal paste, thermal glue and/or a thermal potting material. Member **1202** can be connected between the conductive connection **810** and/or the temperature sensor. Any known or to be known electrically isolating and thermally conductive member can be used here.

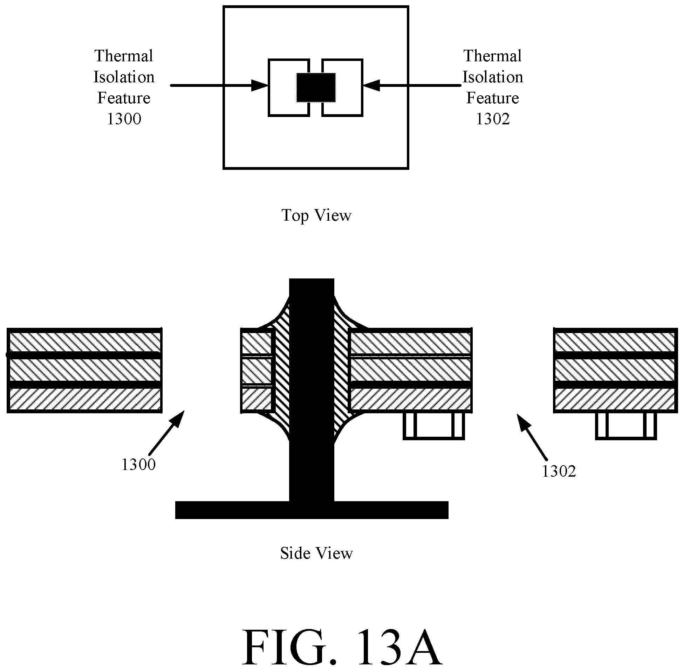

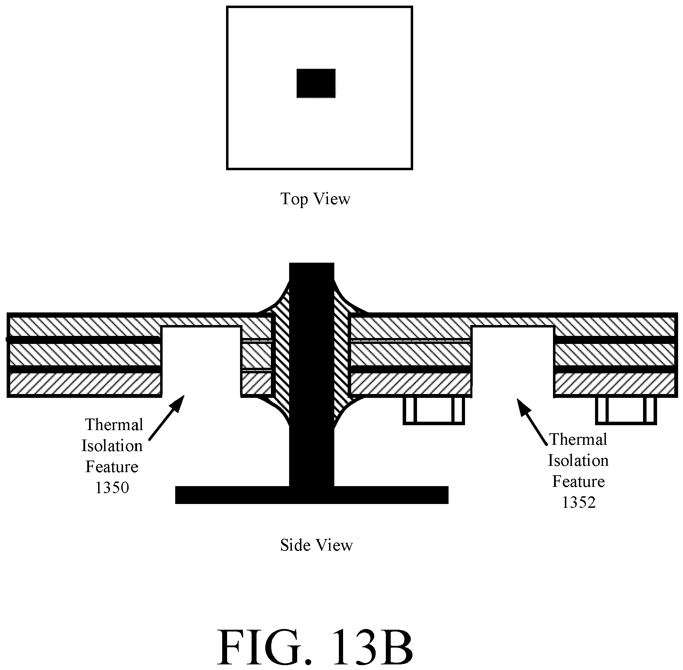

Alternatively or additionally, the circuit board can be milled or otherwise processed so that thermal isolation features are formed as voids therein to provide thermal isolation between area **860** and conductors **840, 842, 846, 848.** The thermal isolation features can extend all the way through the circuit board as shown in FIG. 13A or extend only partially through the circuit board as shown in FIG. 13B.

As noted above, the energy module may comprise a plurality of conductive terminals and a plurality of temperature sensors. An illustrative architecture of this multi-sensor configuration is provided in FIG. 14. FIG. 14A shows a top view of a circuit board **1400** of an energy module that is useful for understanding the relative positions of conductive terminals **1430-1436,** temperature sensors **1402-1408,** and optional internal conductive planes **1440-1448.** Conductive terminals **1430-1436** can include, but are not limited to, conductive terminals **404, 406, 408** of FIG. 4 and/or conductive terminal **804** of FIG. 8. Temperature sensors **1402-1408** can include, but are not limited to, temperature sensors **508** of FIG. 5 and/or temperature sensor **812** of FIG. 8. Conductive planes **1440-1448** can include, but are not limited to, conductive plane **844** of FIG. 8. FIG. 14B shows the electrical connections of the circuit board **1400.**

Blocks **1420, 1422** are also provided in FIGS. 14A-14B for the data processing circuit and other electronic components. The data processing circuit **1420** can include, but is not limited to, data processing circuit **502** of FIG. 5. The other electronic components **1422** can include, but are not limited to, the module temperature sensor **518** of FIG. 5, the selective circuit interrupt **570** of FIG. 5, the voltage regulator **542** of FIG. 5, gate driver **504** of FIG. 5, isolator(s) **540** of FIG. 5, and/or transistor active bridge circuit **550** of FIG. 5.

FIG. 14B shows the electrical connections between the sensors **1402-1408, 1430-1436** and a data processing circuit **1420.** As can be seen, the conductive terminals **1430, 1432, 1434, 1436** have their own electrical connection lines **1440-1446** to respective voltage measurement channels of the data processing circuit **1420.** The electrical connection lines **1440-1446** can be implemented as conductors disposed on the same or different substrate layer of the circuit board **1400.** The data processing circuit **1420** can be configured to compare a cell voltage measurement value received from each of the conductive terminals to a pre-specified reference value. This comparison operation is performed separately for each of the conductive terminals. As such, a voltage measurement value from conductive terminals **1430** may be compared to the reference value prior to, subsequent to and/or at the same time as a voltage measurement value from another conductive terminal **1432, 1434** or **1436** is compared to the same or different reference value.

In contrast, the temperature sensors **1402-1408** are connected to a single temperature measurement channel of the data processing circuit **1420** using a common electrical connection line **1450.** Electrical connection line **1450** can be implemented as conductors (e.g., traces) disposed on the same or different substrate layer of the circuit board.

The present solution will now be explained with the following examples to show ways to reduce measurement channels needed for temperature monitoring of multiple spots or regions of a circuit. In general, the present solution involves arranging a plurality of temperature sensors in such an electrical network that electrical response of the electrical network is not only dependent on the overall behavior of the sensors, but it is dominatable by any one or more of the temperature sensors when those sensors experience larger than nominal temperature variation (e.g., as compared to nominal or acceptable temperature range) than the rest of the sensors. For example, the present solution can be applied to any impedance-based temperature sensors for measuring overtemperature or under-temperature. The following examples are shown with thermistor type sensors in which electrical resistance of the sensor is temperature dependent. It shall be appreciated that other kinds of sensors can also be applied. The present solution can also open several different applications and goals, for example, by employing one or more sensors having higher temperature sensitivity as compared to the others. By doing so, when they are arranged in an electrical network as mentioned above, they can dominate the electrical response of the electrical network with smaller changes in their temperature. This can allow assigning higher temperature sensitivity to certain regions of the circuit (e.g., where these higher temperature sensitivity one or more sensors are provided) as compared to other regions (e.g., where these lower temperature sensitivity sensors are provided). Additionally, or alternatively, sensors with different impedance values (e.g., resistance) can be selected for different regions in order to assign different priority (e.g., measurement weightage or bias) to different regions. These features can be achieved by a single measurement channel (e.g., by measuring at the measurement tap), thereby being particularly suitable for compact applications and/or low-cost applications (e.g., portable power units). The examples below will mostly refer to overtemperature measurements. However, equivalent circuits for under-temperature monitoring can also be realized by arranging given types of sensors in a such a network that electrical response of the electrical network is not only dependent on the overall behavior of the sensors, but it is dominatable by any one or more of the temperature sensors when those sensors experience larger magnitude of under-temperature. Certain examples of the networks will be provided for overtemperature monitoring, but those networks are also usable for under-temperature monitoring with a sensor behavior (e.g., temperature coefficient) which makes the sensor dominant in defining electrical response of the electrical network for the temperatures in which the monitoring should trigger.

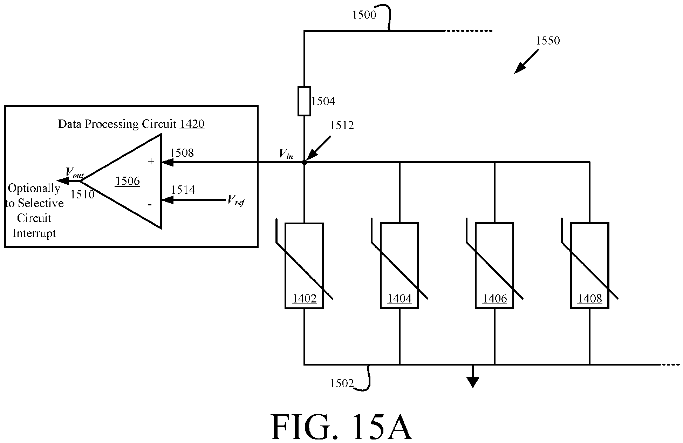

FIG. 15A provides a more detailed circuit diagram **1550** that is useful for understanding the manner in which the cell temperature monitoring is achieved using the temperature sensors **1402-1408** and data processing circuit configuration 1420. In this example, the electrical network comprises a parallel arrangement (e.g., parallelly connected) of temperature sensors **1402-1408,** shown here as thermistors.

As shown in FIG. 15A, the temperature sensors **1402-1408** comprise surface mount thermistors that are connected in parallel between a measurement tap **1512** and a reference potential **1502.** Each thermistor comprises an electrical resistor whose resistance is variable depending on its temperature. For example, the resistance of the thermistor is reduced when the temperature of the electrical resistor increases and is increased when the temperature of the electrical resistor is decreased. It shall be appreciated that a temperature sensor exhibiting such a behavior can be said to have a negative temperature coefficient (NTC). It shall also be appreciated that the present solution is not limited to thermistors, rather any kind of NTC temperature sensor can be applied in the configuration such as the one shown in FIG. 15A.

A resistor **1504** is provided to facilitate measuring an electrical signal (*Vᵢₙ*) at the measurement tap **1512.** The resistor **1504** is connected between the measurement tap **1512** and a DC voltage supply or input line **1500.** In this way, a voltage divider configuration is provided by the resistor **1504** and the parallelly connected thermistors **1402-1408** between input lines **1500, 1502.** The thermistors **1402-1408** in this example are sharing a voltage, i.e., voltage (*Vᵢₙ*) at the measurement tap **1512.** Each thermistor is provided to monitor different physical temperature measurement spots of an energy module. In this voltage divider configuration, the temperature of each thermistor may be unable to be determined because for each voltage value at measurement tap **1512** there may be several combinations of thermistor temperatures associated therewith. For example, the measurement tap has a voltage value when a temperature of thermistor **1402** is higher than all other thermistors **1404-1408,** and has the same voltage value when temperatures of thermistors **1404, 1408** are higher than all other thermistors **1402, 1406.** The measurement tap can also have the same voltage value when the temperate of thermistor **1402** equals the temperature of all other thermistors **1404-1408.** The present solution is not limited to the particulars of this example. However, knowing the exact temperature of each thermistor may not be necessary for detecting when a certain temperature limit of one or more temperature measurement points is exceeded.

Accordingly, the arrangement **1550** can still be used for detecting overtemperature condition at any one or more measurement spots. For example, if temperature is increasing at all thermistors **1402-1408,** the effective resistance of the parallel arrangement will decrease, thereby causing the electrical signal ***Vᵢₙ*** at the measurement tap **1512** to change. This change can be evaluated, for example, via the data processing circuit **1420** to determine an occurrence of a temperature error (e.g., an overtemperature condition). As another example, assuming that the thermistor **1408** is experiencing higher temperature as compared to the rest of the thermistors **1402-1406,** the effective resistance of the parallel arrangement will also decrease, thereby causing the electrical signal ***Vᵢₙ*** at the measurement tap **1512** to change. Also, at one point, the effective resistance of the parallel arrangement will become dominant by resistance value of the thermistor **1408,** thereby allowing determination of an occurrence of a temperature error (e.g., an overtemperature condition) even in local overheating conditions. This can be shown by an example of two resistances **R1** and **R2** connected in parallel. The effective resistance of the network with parallelly connected **R1** and **R2** will be **(R1-R2)/(R1+R2).** Assuming that **R1** << **R2,** the effective resistance approaches (**R1·R2**)/(**R2**)≈ **R1**. A similar behavior can be observed when there are more than two resistances (e.g., resistive temperature sensors) connected in parallel. The present solution thus leverages arranging a plurality of temperature sensors in such an electrical network that electrical response of the electrical network is not only dependent on the overall behavior of the sensors, but it is dominatable by any one or more of the temperature sensors when those sensors experience higher temperature than the rest of the sensors (or lower depending on the configuration). As can be seen with the above non-limiting example, a thermistor having resistance **R1** which is significantly lower than the rest (e.g., due to local overheating) would dominate the effective resistance of parallelly connected thermistors, thus allowing the network to be responsive to a temperature error. It shall be appreciated that such network can allow detection if any one or more sensors are experiencing overtemperature (or under temperature depending on the configuration).

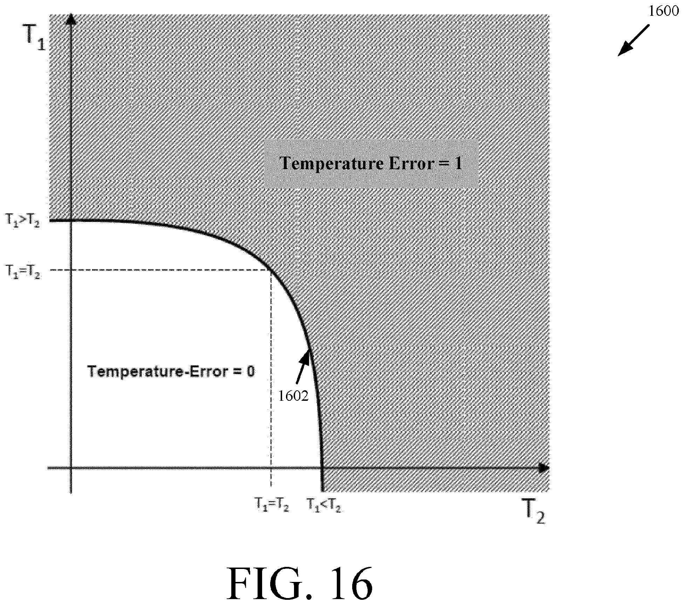

A graph **1600** is provided in FIG. 16 that shows a non-limiting qualitative correlation between two temperatures **T1**, **T2** represented by two parallel NTC thermistors, e.g., **1402, 1404** and a fixed threshold temperature value represented by curve **1602.** FIG. 16 covers a scenario of two parallel NTC sensors (e.g., thermistors) monitored for overtemperature threshold. Graph 1600 shows that even if only one temperature is rising while the other temperature stays significantly lower (e.g., **T1>T2** or **T2>T1**), a temperature error is triggered reliably at a certain adjustable temperature limit. This is because of the lower resistance thermistor dominates in the parallel circuit architecture. Accordingly, in a single electrical energy storage cell failure event, the temperature error is reliably triggered by the data processing circuit **1420** at a certain selected single cell temperature, although the rest of the electrical energy storage cells stay at a comparably low temperature. The temperature limit for the scenario in which all electrical energy storage cells of an energy module have the same temperature is lower as for the single electrical energy storage cell temperature limit. This means that when adjusting the circuit parameters a compromise between single temperature limit and combined temperature limit can be made. The reference voltage **1514** of FIG. 15A can be selected accordingly.

In the non-limiting example shown in FIG. 15A, the data processing circuit **1420** comprises a comparator **1506** with two input terminals **1508, 1514.** The voltage ***Vᵢₙ*** at measurement tap **1512** is provided to input terminal **1508** and a reference voltage ***V_{ref}*** is provided at input terminal **1514.** If voltage ***Vᵢₙ*** is less than the ***V_{ref}***, then the signal state at output terminal **1510** of the comparator is low. In contrast, if voltage ***Vᵢₙ*** is greater than the reference voltage ***V_{ref}***, then the signal state at ***Vₒᵤₜ*** at the output terminal **1510** of the comparator is relatively high. The high valued output ***Vₒᵤₜ*** can, for example, cause a selective circuit interrupt (e.g., selective circuit interrupt **570** of FIG. 5) to transition from a closed state to an open state, whereby the energy flow from the energy storage cells to the input line **510** and active bridge **550** is interrupted. As long as the low signal state at output **1510** exists, the selective circuit interrupt remains in its closed state in which the energy flow from the energy storage cells to the input line **510** and the active bridge **550** is not interrupted . Thus, the selective circuit interrupt can be considered as being normally in a closed state. It shall be appreciated that the data processing circuit **1420** type shown in this example is non-essential and non-limiting to the present teachings. Hence, any other suitable circuit realized in hardware and/or software may be used. As certain non-limiting examples include, ADC, a software module which compares the measured value against a limit, their likes and/or their combinations.

The circuit architecture of FIG. 15A may be used, for example, with negative temperature coefficient (NTC) sensors for overheat detection. This is because the hottest temperature sensor will have the lowest resistance which will dominate the network, and hence lead towards the threshold. If all or most of the temperature sensors are increasing in temperature together, there will be a similar outcome. In other words, the objective is to have the battery module enter a safe mode if there is either local overheating (e.g., one sensor is hot) or the whole energy module is hot.

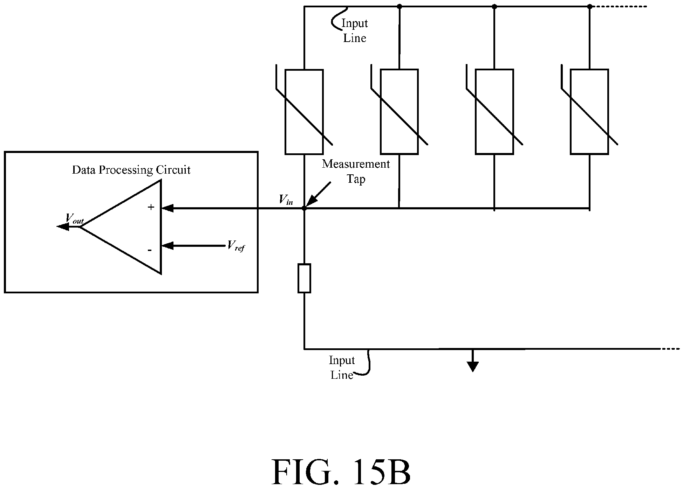

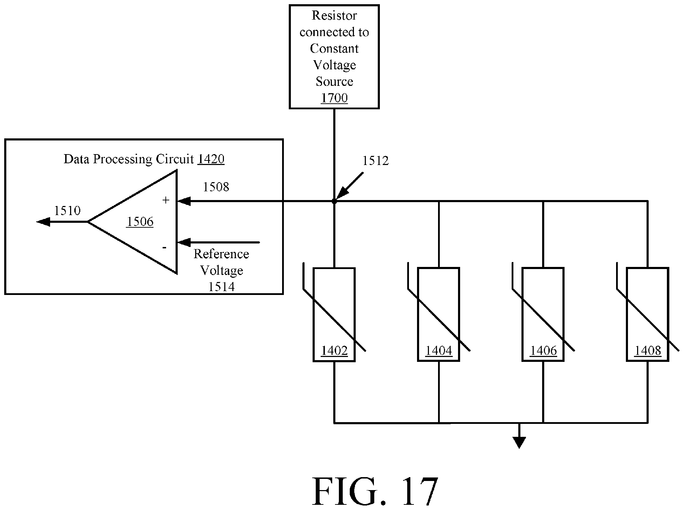

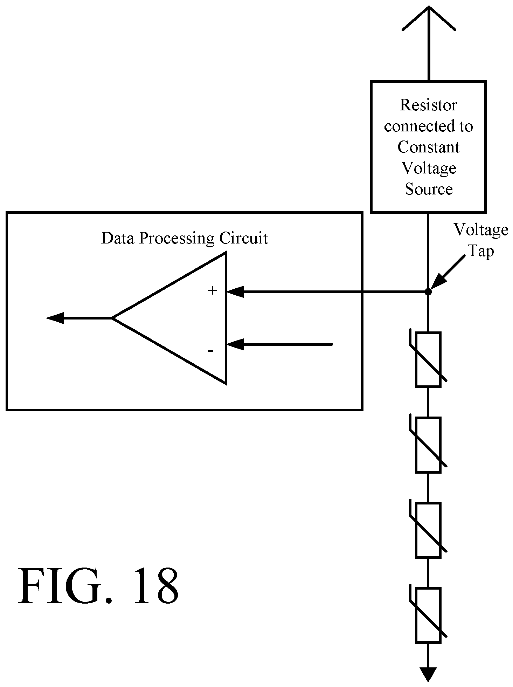

The present solution is not limited to the particulars of FIG. 15A. For example, as shown in FIG. 15B, the locations of the resistor and temperature sensors can be switched in relation to the two input lines. Alternatively, the resistor **1504** may be replaced with a constant current source **1700** as shown in FIG. 17. Additionally or alternatively, the temperature sensors could be coupled in series rather than in parallel to the measurement tap as shown in FIG. 18. In the series configuration, the collective resistance is dominated by the highest resistance. Thus, if positive temperature coefficient (PTC) sensors are used in series, local overheating could be detected by a given temperature sensor with high resistance, and module overheating can be detected as the resistance of all or most of the temperature sensors increase - hence increasing the total series resistance as well. A series network with PTC sensors is thus another example of the network which can allow detection when any one or more sensors are experiencing overtemperature. It shall be appreciated that the block located on the upper side of the "Voltage Tap", i.e., the block called "Resistor connected to Constant Voltage Source" as shown in FIG. 18 in some non-limiting embodiments may be replaced by a current source. Similarly, in some non-limiting embodiments, the temperature sensors coupled in series may be located on the upper side of the voltage tap, while the resistor may be located on the lower side of the voltage tap. Similarly, in some non-limiting embodiments, such the lower side resistor may be replaced by a current sink which draws current from the voltage tap towards a lower potential (e.g., ground potential). Hence, more generally, the sensor position and the resistor/current source/sink position may be flipped in certain embodiments without limiting the scope and generality of the present teachings. Furthermore, the polarity of inputs of comparator (e.g., comparator **1506)** shown in any of the Figures herein disclosed is non-limiting to the generality or scope of the present teachings. It shall be appreciated that the polarity may be opposite in some non-limiting embodiments. For example, FIG. 17 shows the tap **1512** coupled to "+" input of comparator **1506,** while reference voltage **1514** is connected to "-" input of comparator 1506. It shall be appreciated that the tap **1512** is coupled to "-" input of comparator **1506,** while reference voltage **1514** is connected to "+" input of comparator **1506,** without departing from the present teachings. This may cause a change in output polarity of the comparator **1506,** however this can still be utilized for the purposes of the present teachings as herein disclosed.

It should be noted that an overtemperature (higher temperatures dominate) may be monitored by NTC sensors in parallel or PTC sensors in series. An undertemperature (lower temperatures dominate) may be monitored by NTC sensors in series and PTC sensors in parallel. Other types of temperature sensing elements can be used such as platin sensors. Additionally, or alternatively, sensors with different resistance values and/or sensitivities can be used for different spots so as to achieve different monitoring priority and/or sensitivity for those spots. For example, any sensor may be provided a lower nominal resistance value in a parallel network such that it is more dominant than the rest, and/or any sensor may be provided with a larger negative temperature coefficient than the rest such that temperature changes become more dominant with a smaller change in the temperature. Similarly, in other kinds of networks too, different weightage and/or sensitivities can be achieved by selecting sensor characteristics accordingly which cause certain sensors to dominate the network response.

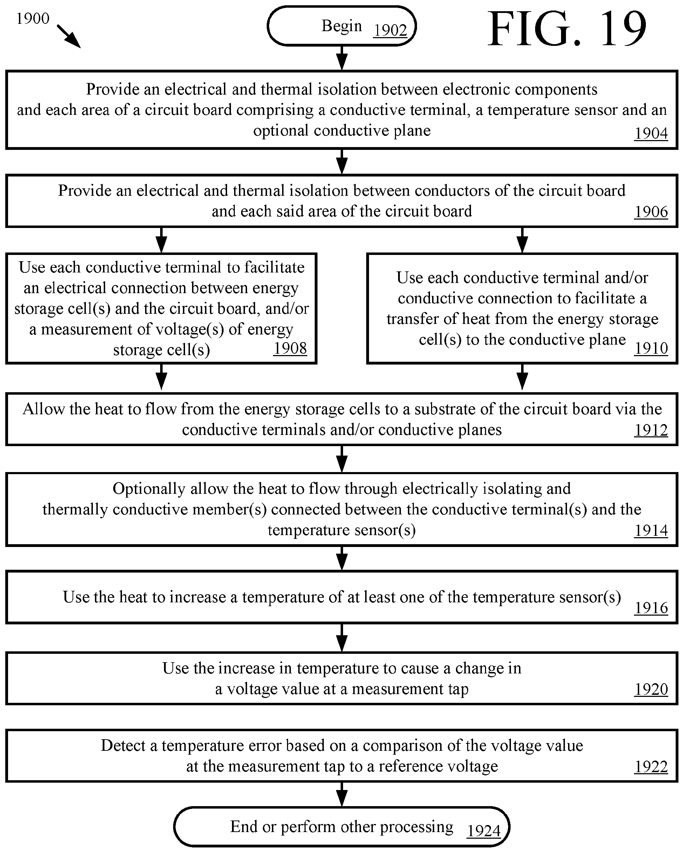

FIG. 19 provides a flow diagram of an illustrative method 1900 for operating an energy module. The operations of blocks of FIG. 19 can occur in a different order than that shown. Method 1900 can additionally or alternatively include more or less blocks than that shown.

Method 1900 begins with 1902 and continues with 1904 where an electrical and thermal isolation is provided between electronic component(s) of the circuit (e.g., component(s) **814** of FIG. 8) and an area (e.g., area **860** of FIG. 8) of a circuit board (e.g., circuit board **802** of FIG. 8) comprising a conductive terminal (e.g., conductive terminal **804** of FIG. 8), a temperature sensor (e.g., temperature sensor **812** of FIG. 8) and an optional conductive plane (e.g., conductive plane **844** of FIG. 8). The thermal isolation is provided by one or more gaps (e.g., gaps **852, 856** of FIG. 8, thermal isolation features **1300, 1302** of FIG. 13A, and/or thermal isolation features **1350, 1352** of FIG. 13) located on and within the circuit board between the other electronic components and the area. The gap(s) is(are) filled with a gas (e.g., air) or a portion of at least one material forming the circuit board or any other material providing thermal isolation. An electrical and thermal isolation is also provided in **1906** between conductors (e.g., conductors **840, 842, 846, 848** of FIG. 8) of the circuit board and the area of the circuit board comprising the conductive terminals, the temperature sensor and/or the conductive plane.

In **1908,** the conductive terminal is used to facilitate (i) an electrical connection between energy storage cell(s) and the circuit board and/or (ii) a measurement of voltage(s) of electrical energy storage cell(s) (e.g., electrical energy storage cell **902₁** and/or **902₂** of FIG. 9). As such, the conductive terminal is electrically connected to a data processing circuit (e.g., data processing circuit **502** of FIG. 5) so that the voltage measurement can be analyzed to detect when the electrical energy storage cell(s) are not operating as expected such as when the cell voltage falls outside an acceptable range of voltage values. This electrical connection between the conductive terminal and the data processing circuit may be made using a conductor or a conductive plane disposed on a substrate layer of the circuit board.

The conductive terminal is also used in **1910** to facilitate a transfer of heat from the electrical energy storage cell(s) to the conductive plane provided within the circuit board. **1910** may also optionally involve using a conductive connection, provided between the conductive terminal and the circuit board, to further facilitate the transfer of heat from the electrical energy storage cell to the conductive plane.

In **1912,** heat is allowed to flow from the electrical energy storage cell to a substrate (e.g., substrate layer **830** of FIG. 8) of the circuit board via the conductive terminal, conductive connection and/or the conductive plane. The heat may also optionally be allowed to flow in **1914** through an electrically isolating and thermally conductive member (e.g., electrically isolating and thermally conductive member **1202** of FIG. 12) that is connected between the conductive connection and the temperature sensor.

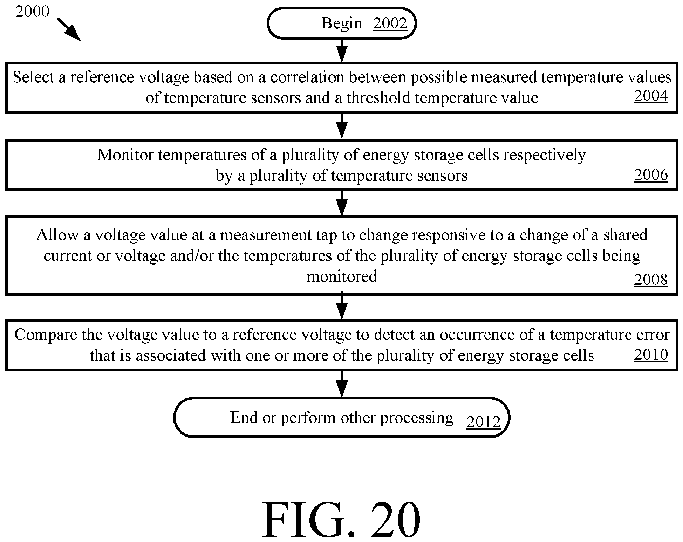

In **1916,** the heat is used to increase a temperature of the temperature sensors(s). The increase in temperature is used in **1918** to cause a change in a voltage value at a measurement tap. The measurement tap can include, but is not limited to, a voltage tap of a voltage divider (e.g., voltage divider **1550** of FIG. 15) disposed on the circuit board. A temperature error is detected in **1922** based on a comparison of the voltage value (e.g., voltage ***Vᵢₙ*** of FIG. 15) at the measurement tap to a reference voltage (e.g., voltage ***V_{ref}*** of FIG. 15). Subsequently, method **1900** continues to block **1924** where it ends or other operations are performed. The other operations can include, but are not limited to, returning to block **1902** or continue to block **2002** of FIG. 20.

FIG. 20 provides a flow diagram of another illustrative method **2000** for operating an energy module (e.g., energy module **300** of FIGS. 3-4). The operations of blocks **2002-2012** can occur in a different order than that shown. Method **2000** can additionally or alternatively comprise more or less blocks than that shown.

Method **2000** begins with **2002** and continues with **2004** where a reference voltage (e.g., ***V_{ref}*** of FIG. 15) is selected based on a correlation between possible measured temperature values a plurality of temperature sensors and a threshold temperature value.

In **2006,** temperatures of a plurality of electrical energy storage cells (e.g., electrical energy storage cells **400** of FIGS. 4-5, and/or electrical energy storage cells **902₁**, **902₂** of FIGS. 9-10) are monitored respectively by the temperature sensors (e.g., temperature sensors **508** of FIG. 5, temperature sensor **812** of FIG. 8, and/or temperature sensors **1402-1408** of FIG. 14). The temperature sensors may include thermistors. The temperature sensors are arranged in a network such that each temperature sensor shares a current or voltage with at least another temperature sensor. The temperature sensors may be mounted to a surface of a circuit board (e.g., circuit board **802** of FIG. 8 and/or **1400** of FIG. 14) that is (i) internal to the energy module and (ii) spaced apart from the energy storage cells. In **2006,** heat may be allowed to flow from the electrical energy storage cell(s) to a substrate (e.g., substrate layer **830** of FIG. 8) of the circuit board, for example, via an optional conductive terminal(s) (e.g., conductive terminal **804** of FIG. 8). This heat may be used to increase a temperature of one or more temperature sensors. Notably, the substrate may be used in block **2006** to electrically isolate the respective temperature sensor from the conductive terminal.

Responsive to a change of the shared current or voltage and/or the monitored temperatures of the electrical energy storage cells, a voltage value at a measurement tap (e.g., measurement tap **1512** of FIG. 15) is allowed to change in block **2008.** The change in the shared current or voltage may be caused by the temperatures of the electrical energy storage cells being monitored. The measurement tap can include, but is not limited to, a voltage tap of a voltage divider (e.g., voltage divider **1550** of FIG. 15). For example, the increase in the temperature of the temperature sensor(s) causes the change in the voltage value at the measurement tap. The voltage divider may comprise (1) a resistor (e.g., resistor **1504** of FIG. 15) connected between a first input line (e.g., input line **1500** of FIG. 15) and the measurement tap and (2) the plurality of temperature sensors connected in series or parallel between the measurement tap and a second input line (e.g., input line **1502** of FIG. 15). The first or second input lines may be connected to ground. The present solution is not limited to the particulars of this example.

Block **2010** can involve comparing the voltage value to a reference voltage to detect an occurrence of a temperature error that is associated with the energy module and/or one or more of the plurality of energy storage cells. It should be noted here that the voltage value represents or otherwise indicates a combined temperature of the energy storage cells rather than a temperature of a single energy storage cell. Subsequently, method **2000** continues to block **2012** where it ends or other operations are performed (e.g., return to **2002** or perform method **1900** of FIG. 19).

Although the present solution has been illustrated and described with respect to one or more implementations, equivalent alterations and modifications will occur to others skilled in the art upon the reading and understanding of this specification and the annexed drawings. In addition, while a particular feature of the present solution may have been disclosed with respect to only one of several implementations, such feature may be combined with one or more other features of the other implementations as may be desired and advantageous for any given or particular application. Thus, the breadth and scope of the present solution should not be limited by any of the above described scenarios. Rather, the scope of the present solution should be defined in accordance with the following claims and their equivalents.

Without excluding further possible embodiments, certain example embodiments are summarized in the following clauses:
Clause 1: An energy module, comprising: a plurality of electrical energy storage cells; a plurality of temperature sensors configured to monitor temperatures of the plurality of electrical energy storage cells (e.g., the plurality of temperature sensors being arranged in a network such that each temperature sensor shares a current or voltage with at least another temperature sensor in the plurality of temperature sensors); a measurement tap in the network, which has a signal value that will change responsive to a change of the shared current or voltage (e.g., wherein the change in the shared current or voltage is caused by the temperatures of the plurality of electrical energy storage cells being monitored); and a circuit configured to detect an occurrence of a temperature error that is associated with one or more of the plurality of energy storage cells based on the signal value at the measurement tap.
Clause 2: The energy module of clause 1, wherein the circuit detects an occurrence of the temperature error by comparing the signal value (e.g., a voltage) to a reference value (e.g., a reference voltage value).
Clause 3: The energy module of any of the preceding clauses, wherein the reference value (e.g., reference voltage value) is selected based on a qualitative correlation between possible measured temperature values of the plurality of temperature sensors and a threshold temperature value.
Clause 5: The energy module of any of the preceding clauses, wherein the network comprises a voltage divider.
Clause 5: The energy module of any of the preceding clauses, wherein the voltage divider comprises (1) a resistor connected between a first input line and the measurement tap and (2) the plurality of temperature sensors connected in parallel or series between the measurement tap and a second input line, wherein the first or second input line is connected to reference potential (e.g., ground potential) and the other input line to a voltage or current source.
Clause 6: The energy module of any of the preceding clauses, further comprising a current source connected between a first input line and the measurement tap, and wherein the plurality of temperature sensors are connected in parallel or series between the measurement tap and a second input line.
Clause 7: The energy module of any of the preceding clauses, wherein the temperature error comprises an overtemperature or an undertemperature of the energy module or one of the plurality of temperature sensors.
Clause 8: The energy module of any of the preceding clauses, wherein the overtemperature is detected using negative temperature coefficient sensors connected in parallel or positive temperature coefficient sensors connected in series.
Clause 9: The energy module of any of the preceding clauses, wherein the undertemperature is detected using negative temperature coefficient sensors connected in series or positive temperature coefficient sensors connected in parallel.
Clause 10: The energy module of any of the preceding clauses, wherein each of the plurality of temperature sensors is mounted to a surface of a circuit board that is (i) internal to the energy module and (ii) spaced apart from the plurality of electrical energy storage cells.
Clause 11: The energy module of any of the preceding clauses, wherein a temperature and/or resistance of a respective temperature sensor of the plurality of temperature sensors changes responsive to heat thermally conducted from one or more of the plurality of energy storage cells to a substrate of the circuit board.
Clause 12: A method for operating an energy module, comprising: monitoring temperatures of a plurality of electrical energy storage cells respectively by a plurality of temperature sensors (wherein plurality of temperature sensors are arranged in a network such that each temperature sensor shares a current or voltage with at least another temperature sensor in the plurality of temperature sensors); allowing a voltage value at a measurement tap to change responsive to a change of the shared current or voltage, wherein the change in the shared current or voltage is caused by the temperatures of the plurality of electrical energy storage cells being monitored; and comparing the voltage value to a reference voltage to detect an occurrence of a temperature error that is associated with one or more of the plurality of electrical energy storage.
Clause 13: The method of clause 12, further comprising selecting the reference voltage based on a correlation between possible measured temperature values of the plurality of temperature sensors and a threshold temperature value.
Clause 14. The method of any of the preceding method clauses, wherein the network comprises a voltage divider.
Clause 15: The method of any of the preceding method clauses, wherein the voltage divider comprises (1) a resistor connected between a first input line and the measurement tap and (2) the plurality of temperature sensors connected in parallel or series between the measurement tap and a second input line, the first or second input line being connected to ground or a reference potential and the other input one to a DC voltage supply.
Clause 16: The method of any of the preceding method clauses, wherein the network comprises a current source connected between a first input line and the measurement tap, and wherein the plurality of temperature sensors are connected in parallel or series between the measurement tap and a second input line.
Clause 17: The method of any of the preceding method clauses, wherein the temperature error comprises an over temperature or an undertemperature of the energy module or one of the plurality of temperature sensors.
Clause 18: The method of any of the preceding method clauses, wherein the over temperature is detected using negative temperature coefficient sensors connected in parallel or positive temperature coefficient sensors connected in series.
Clause 19: The method of any of the preceding method clauses, wherein undertemperature is detected using negative temperature coefficient sensors connected in series or positive temperature coefficient sensors connected in parallel.
Clause 20: The method of any of the preceding method clauses, wherein each of the plurality of temperature sensors comprises a sensor mounted to a surface of a circuit board that is (i) internal to the energy module and (ii) spaced apart from the plurality of electrical energy storage cells, and a temperature and/or resistance of a respective temperature sensor of the plurality of temperature sensors changes responsive to heat thermally communicated from one or more of the plurality of energy storage cells to a substrate of the circuit board.
Clause 21: A system (e.g., an energy module) comprising means for performing the steps of any of the above method clauses.
Clause 22: A software product comprising instructions which when executed by one or more suitable processors (e.g., those of a system or an energy module) cause any of the processors to perform the steps of any of the above method clauses.
The breadth and scope of this disclosure should not be limited by any of the above-described example embodiments, but should be defined only in accordance with the following claims and their equivalents.

## Claims

1. An energy module, comprising:
a plurality of electrical energy storage cells;
a plurality of temperature sensors configured to monitor temperatures of the plurality of electrical energy storage cells, the plurality of temperature sensors being arranged in a network such that each temperature sensor shares a current or voltage with at least another temperature sensor in the plurality of temperature sensors;
a measurement tap in the network, which has a signal value that will change responsive to a change of the shared current or voltage, wherein the change in the shared current or voltage is caused by the temperatures of the plurality of electrical energy storage cells being monitored; and
a circuit configured to detect an occurrence of a temperature error that is associated with one or more of the plurality of energy storage cells based on the signal value at the measurement tap.

2. The energy module according to claim 1, wherein the circuit detects an occurrence of the temperature error by comparing the signal value to a reference value.

3. The energy module according to claim 2, wherein the reference value is selected based on a correlation between possible measured temperature values of the plurality of temperature sensors and a threshold temperature value.

4. The energy module according to any of the above claims, wherein the network comprises a voltage divider, which voltage divider comprises (1) a resistor connected between a first input line and the measurement tap and (2) the plurality of temperature sensors connected in parallel or series between the measurement tap and a second input line, wherein the first or second input line is connected to reference potential and the other input line to a voltage source or a current source.

5. The energy module according to any of the preceding claims, wherein the temperature error comprises an overtemperature or an undertemperature of the energy module or one of the plurality of temperature sensors.

6. A method for operating an energy module, comprising:
monitoring temperatures of a plurality of electrical energy storage cells respectively by a plurality of temperature sensors, wherein plurality of temperature sensors are arranged in a network such that each temperature sensor shares a current or voltage with at least another temperature sensor in the plurality of temperature sensors;
allowing a voltage value at a measurement tap to change responsive to a change of the shared current or voltage, wherein the change in the shared current or voltage is caused by the temperatures of the plurality of electrical energy storage cells being monitored; and
comparing the voltage value to a reference voltage to detect an occurrence of a temperature error that is associated with one or more of the plurality of electrical energy storage.

7. The method according to claim 6, further comprising selecting the reference voltage based on a qualitative correlation between possible measured temperature values of the plurality of temperature sensors and a threshold temperature value.

8. The method according to any of the preceding method claims, wherein the network comprises a voltage divider.

9. The method according to claim 8, wherein the voltage divider comprises (1) a resistor connected between a first input line and the measurement tap and (2) the plurality of temperature sensors connected in parallel or series between the measurement tap and a second input line, the first or second input line being connected to a reference potential and the other input one to a voltage or current source.

10. The method according to any of the preceding method claims, wherein the network comprises a current source connected between a first input line and the measurement tap, and wherein the plurality of temperature sensors are connected in parallel or series between the measurement tap and a second input line.

11. The method according to any of the preceding method claims, wherein the temperature error comprises an over temperature or an undertemperature of the energy module or one of the plurality of temperature sensors.

12. The method according to claim 11, wherein the over temperature is detected using negative temperature coefficient sensors connected in parallel or positive temperature coefficient sensors connected in series.

13. The method according to claim 11 or 12, wherein undertemperature is detected using negative temperature coefficient sensors connected in series or positive temperature coefficient sensors connected in parallel.

14. The method according to any of the preceding method claims, wherein each of the plurality of temperature sensors comprises a sensor mounted to a surface of a circuit board that is (i) internal to the energy module and (ii) spaced apart from the plurality of electrical energy storage cells, and a temperature and/or resistance of a respective temperature sensor of the plurality of temperature sensors changes responsive to heat thermally communicated from one or more of the plurality of energy storage cells to a substrate of the circuit board.

15. A system comprising means for performing the steps of any of the above method claims.
